# EUROPEAN PATENT APPLICATION

(11) **EP 4 624 382 A1**
(43) Date of publication of application: **01.10.2025**
(21) Application number: 24793108.2
(22) Date of filing: 14.03.2024
(51) Int. Cl.: B65G 41/00, B65G 49/06, B62B 5/00

(54) **TRANSPORT SYSTEM AND TRANSPORT METHOD**

(30) Priority: 17.04.2023 KR 20230050253
(71) Applicant: Hanwha Solutions Corporation, Seoul 04541 (KR)
(72) Inventor: JUNG, Hyun Seok, Seoul 04541 (KR); LEE, Jong Won, Seoul 04541 (KR); KIM, Seung Jin, Seoul 04541 (KR); LEE, Sang Ryeol, Seoul 04541 (KR); CHOI, Yong Ho, Seoul 04541 (KR)
(74) Representative: Mooser, Sebastian Thomas
(86) International application number: PCT/KR2024/095529
(87) International publication number: WO 2024/219924

(57) **Abstract**

A transport system includes a transport device including a first transport member configured to transport an object, a first driving member configured to drive the first transport member, and a first docking device, and an input device including a second transport member configured to transport the object, a second driving member configured to drive the second transport member, and a second docking device, wherein the first docking device includes a first connection pin, and the second docking device includes a second connection pin, wherein the second docking device pulls the first docking device to the input device and connects the second connection pin to the first connection pin to connect a power source to the transport device.

## Description

### [Technical Field]

The present disclosure relates to a transport system and a transport method.

### [Background Art]

In a transport device, a worker directly pushes a cart loaded with an object to move the cart to an object device, or an auto guided vehicle (AGV) or an autonomous mobile robot (AMR) is used to transport the cart to the object device. In order to transport an object from a transport device to an object device, the transport device and the object device should be docked at an exact position, but an AGV or AMR cannot automatically dock the transport device and the object device due to accompanying inevitable errors. Therefore, there is an inconvenience that a worker should manually align and then dock a transport device to an object device and then should connect a power source to the transport device to transport an object.

To solve these problems, there are cases in which a conveyor is installed integrally with an AGV or AMR, and power is supplied to the conveyor to transport an object from a transport device to an object device. However, even in this case, there is a problem that, since it is difficult to precisely dock the AGV or AMR to the object device, docking attempts are repeated such that the work time and the workload of a worker increase. In particular, there is a problem that an object is damaged due to a step difference or a position difference between a conveyor of a transport device and a conveyor of an object device, and a lot of time is required for maintaining and repairing a device.

### [Disclosure]

### [Technical Problem]

According to a transport system and a transport method according to various embodiments of the present disclosure, there are provides a transport system and a transport method which are capable of accurately aligning a transport device with an object device and automatically docking the transport device to the object device when a worker manually transports the transport device, or an auto guided vehicle (AGV) or an autonomous mobile robot (AMR) is used to transport the transport device.

### [Technical Solution]

A transport system includes a transport device including a first transport member configured to transport an object, a first driving member configured to drive the first transport member, and a first docking device, and an input device including a second transport member configured to transport the object, a second driving member configured to drive the second transport member, and a second docking device, wherein the first docking device includes a first connection pin, and the second docking device includes a second connection pin, wherein the second docking device pulls the first docking device to the input device and connects the second connection pin to the first connection pin to connect a power source to the transport device.

The first docking device may include a first base configured to support the first connection pin and a guide plate connected to the first base and including an insertion groove, the second docking device may include a second base configured to support the second connection pin, a first movable member configured to move the second base forward or rearward, a second movable member configured to raise or lower the second base, a docking pin which is connected to the second base and has an upper portion having a shape of which a cross-sectional decreases in an upward direction, and a sensor, and when the sensor detects the transport device, the first movable member and the second movable member may operate to insert the docking pin into the insertion groove and then may pull the first docking device to the first docking device.

The first docking device may further include a pair of guide blocks located at both sides of the first base and each including an inclined surface on an inner surface facing the first base, and the second docking device may further include a pair of rollers located at both sides of the second base and having an interval that is less than an interval between the pair of guide blocks, and a pair of alignment protrusions located outside the pair of rollers and each having an inclined surface at an outer side thereof.

The first docking device may further include a support plate located on the first base, a slider located on the support plate and movable in a width direction, and an elastic member located on the support plate, and the insertion groove may have a shape of which a dimension in a longitudinal direction is greater than a dimension in a width direction and may include an inclined surface having a shape of which a cross-sectional area decreases in an upward direction and a vertical surface extending from the inclined surface.

The transport device may not include a power source, and when the second connection pin is connected to the first connection pin, the second docking device may supply power from the power source to the transport device to operate the first driving member.

The first transport member may further include a coupler which is rotatable and includes a coupling groove formed in a leading end portion, and the second transport member may further include a coupling protrusion coupled to the coupling groove of the coupler.

A transport method includes moving a transport device to an input device, detecting, by a second docking device of the input device, the transport device, inserting, by a first movable member and a second movable member, a docking pin of the second docking device into an insertion groove of a first docking device of the transport device, pulling, by the first movable member, the first docking device to the second docking device, and connecting a first connection pin of the first docking device to one or more second connection pins of the second docking device to connect a power source to the transport device.

After the docking pin is inserted into the insertion groove, the first movable member may operate to move the docking pin forward, and then the second movable member may operate to raise and insert the docking pin into the insertion groove, and the pulling of the first docking device to the second docking device may include operating the first movable member to move the docking pin inserted into the insertion groove rearward.

After the power source is connected to the transport device, the first transport member of the transport device may receive power from the power source to transport an object to the second transport member of the input device.

After the first transport member pulls the first docking device to the second docking device, the first transport member of the transport device may be connected to the second transport member of the input device through a coupler.

### [Advantageous Effects]

According to a transport system and a transport method according to various embodiments of the present disclosure, even in a state in which a transport device transporting an object is not properly aligned with an input device, the transport device can be smoothly docked to the input device.

### [Description of Drawings]

FIG. 1 schematically illustrates a transport system.
FIG. 2 shows a side view of the transport system.
FIG. 3 shows a top view of the transport system.
FIG. 4 illustrates a first docking device.
FIG. 5 is a cross-sectional view along line V-V' of FIG. 4.
FIG. 6 is an enlarged view of a guide block.
FIG. 7 is an enlarged view of a part of an input device.
FIG. 8 illustrates a second docking device.
FIG. 9 illustrates a part of the second docking device.
FIG. 10 is an enlarged view of a part of a transport device and the input device.
FIGS. 11, 12, and 13 illustrate the operation of a coupler.
FIG. 14 is a control block diagram of a docking controller.
FIGS. 15 to 22 illustrate docking and undocking operations of the transport device and the input device.

### [Best Mode]

A transport system includes a transport device including a first transport member configured to transport an object, a first driving member configured to drive the first transport member, and a first docking device, and an input device including a second transport member configured to transport the object, a second driving member configured to drive the second transport member, and a second docking device, wherein the first docking device includes a first connection pin, the second docking device includes a second connection pin, the second docking device may pull the first docking device to the input device and may connect the second connection pin to the first connection pin to connect a power source to the transport device.

### [Modes of the Invention]

Some embodiments of the present disclosure and a method according thereto may be understood with reference to the detailed description of the embodiments and the drawings. Embodiments to be described below have various modified examples and may be implemented in other forms, which are not limited to the embodiments described in the present specification. Furthermore, some or all of the features of each of various embodiments of the present disclosure may be combined with each other. Respective embodiments may be implemented independently of each other or may be implemented together in association with each other. The embodiments to be described below are provided as examples to make the present disclosure thorough and complete and also are intended to completely convey the idea of the present disclosure to those skilled in the art to which the present disclosure pertains. It is to be appreciated that all changes, equivalents, and substitutes that do not depart from the spirit and technical scope of the disclosure are encompassed in the present disclosure. Accordingly, for full understanding of embodiments of the present disclosure, processes, elements, and techniques, which are unnecessary to a person skilled in the art, may not be described.

Unless otherwise stated throughout the accompanying drawings and specifications, like reference numerals denote like elements, and thus descriptions thereof will not be repeated. In addition, in order to clearly describe the present disclosure, parts unrelated to the description have been omitted.

In the drawings, the relative sizes of elements, layers, and regions may be exaggerated for clarity. The use of hatching and/or shading in the accompanying drawings is generally provided to clarify boundaries between adjacent elements. Accordingly, the presence or absence of hatching or shading does not indicate the desired forms or requirements for a specific material, material characteristic, dimensions, proportions, commonality between drawing elements, and/or other characteristics, properties, attributes, etc. of an element unless otherwise specified.

Various embodiments are described herein with reference to cross-sectional examples, which are schematic illustrations of embodiments and/or intermediate structures. Thus, the appearance of the drawings may vary, for example, as a result of manufacturing techniques and/or tolerances. In addition, the specific structural or functional descriptions disclosed in this specification are merely examples to describe embodiments according to the concept of the present disclosure. Accordingly, the embodiments disclosed herein should not be construed as being limited to the shapes of the illustrated areas, and include, for example, variations in shape due to manufacturing.

The areas illustrated in the drawings are schematic in nature and their shapes are not intended to illustrate the actual shape of an area of a device and are not intended to limit the scope of the present disclosure. Furthermore, as will be appreciated by those skilled in the art, the described embodiments may be modified in various ways without departing from the spirit or scope of the present disclosure.

Numerous specific details are set forth in the specification to provide a thorough understanding of the various embodiments. However, various embodiments may be practiced without or including one or more of these specific details. In other cases, well-known structures and devices are shown in the form of a block diagram to avoid unnecessarily obscuring various embodiments.

As illustrated in the drawings, in order to describe the relationship between one element or feature and another element or feature, for ease of description here, spatially relative terms such as "below," above," "beneath," "on," etc. may be used. The spatially relative terms are intended to include various orientations of a device in use or operation in addition to the orientations shown in the drawings. For example, when the device in the drawing is turned over, other elements or features described as "below" or "beneath" will "above" the other elements or features. Accordingly, as illustrative terms, "below" and "beneath" can include both up and down directions. The device may be oriented in different directions (e.g., rotated 90 degrees or in other directions), and the spatially relative descriptions used in the specification should be interpreted accordingly. Likewise, when a first part is described as being disposed "above" a second part, this means that the first part is disposed above or below the second part.

In addition, the expression "plan view" means that an object part is viewed from above, and the expression "in a schematic cross-sectional view" means that a schematic cross-sectional view is taken by cutting the object part vertically. The term "side view" means that a first object can be above, below, or on the side surface of a second object, and vice versa. In addition, the term "overlapping" or "superimposing" may include layers, stacks, surfaces, extending, covering, or partially covering, or any other suitable term that a person skilled in the art understands. The expression "does not overlap" may include meanings such as "apart from something" or "separated from something" and any other suitable equivalent recognized and understood by a person skilled in the art. The terms "face" and "surface" may mean that a first object can directly or indirectly face a second object. When there is a third object between the first and second objects, the first and second objects face each other, but can be indirectly understood as opposite to each other.

It will be understood that when a layer, region, or component is referred to as being "formed on," "connected to," or "coupled to" another layer, region, or component, it can be directly or indirectly formed on the other layer, region, or component. In addition, it can collectively refer to the direct or indirect combination or connection or the integrated or non-integrated combination or connection of elements, layers, areas, or components so that one or more elements, layers, areas, or components may be present. For example, when an element, layer, area, or component is referred to as "electrically connected to" or "electrically coupled" to another element, layer, area, or component, it may be directly electrically connected or electrically coupled to another element, layer, area, or component, or other elements, layers, areas, or components may be present. However, "directly connected" or "directly coupled" means that one component is directly connected or coupled to another component without an intermediate component or is on top of another component. Furthermore, in the specification, when a part of a layer, film, area, guide plate, or the like is formed on another part, the formation direction is not limited to the upper direction and includes that the part is formed on the side surface or lower portion. Conversely, when a part of a layer, film, area, guide plate, or the like is formed "below" another part, this includes not only the case in which the part is "immediately below" the other part, but also the case in which there is another part between the part and the other part. Meanwhile, other expressions that describe relationships between components, such as "between," "right between" or "adjacent to" and "immediately adjacent to," may also be interpreted similarly. Furthermore, when an element or layer is referred to as being "between" two elements or layers, it may be the only element between the two elements or layers, or there may be other elements therebetween.

For the purposes of this specification, expressions such as "at least one" or "any one" do not limit the order of individual elements. For example, "at least one of X, Y, and Z," "at least one of X, Y, or Z," and "at least one selected from the group consisting of X, Y, and Z" may include X alone, Y alone, Z alone, and any combination of two or more of X, Y, and Z. Similarly, expressions such as "at least one of A and B" and "at least one of A or B" may include A, B, or A and B. As used herein, the term "and/or" includes any combination of one or more related list items. For example, an expression such as "A and/or B" may include A, B, or A and B.

Although terms such as "first," "second," "third," or the like may be used herein to describe various elements, components, areas, layers, and/or cross-sections, such elements, components, areas, layers, and/or cross-sections are not limited by these terms. These terms are used to distinguish one element, component, area, layer, or cross-section from another element, component, area, layer, or cross-section. Accordingly, a first element, component, area, layer, or cross-section described below may be referred to as a second element, component, area, layer, or cross-section without departing from the spirit and scope of the present disclosure. Describing an element as a "first" element may not require or imply the presence of a second element or any other element. Terms such as "first," "second," or the like may be used in the specification to distinguish different categories or sets of elements. For clarity, terms such as "first" and "second" may be expressed as "first category (or first set)," "second category (or second set)," and the like, respectively.

The terms used herein are merely used to describe specific embodiments and are not intended to limit the disclosure. In the specification, the singular is intended to include the plural, and the plural is also intended to include the singular, unless the context clearly dictates otherwise. The terms "comprise," "have," and the like when used in the specification mean to specify the presence of a specified feature, integer, or step. These expressions do not exclude the presence or addition of one or more other functions, steps, operations, components, and/or groups thereof.

When one or more embodiments may be implemented differently, the specific process order may be performed differently from the described order. For example, two consecutively described processes may be performed substantially simultaneously or may be performed in the reverse order from the described order.

As used herein, the terms "substantially," "about," and similar terms are used as terms of approximation and not as terms of degree, and are intended to account for the inherent variations in measured or calculated values that would be recognized by those of ordinary skill in the art. "About" or "approximately" as used herein is inclusive of the stated value and means within an acceptable range of deviation for the particular value as determined by one of ordinary skill in the art, considering the measurement in question and the error associated with the measurement of a particular quantity (i.e., the limitations of the measurement system). For example, "about" can mean within one or more standard deviations, or within ±30%, 20%, 10% or 5% of the stated value.

Unless defined otherwise, all the terms (including technical and scientific terms) used herein have the same meaning as commonly understood by one of ordinary skill in the art to which the present invention belongs. Terms defined in commonly used dictionaries should be interpreted to have a meaning consistent with their meaning in the context of the relevant art and/or this specification and will not be interpreted in an idealized or overly formal sense unless expressly defined herein.

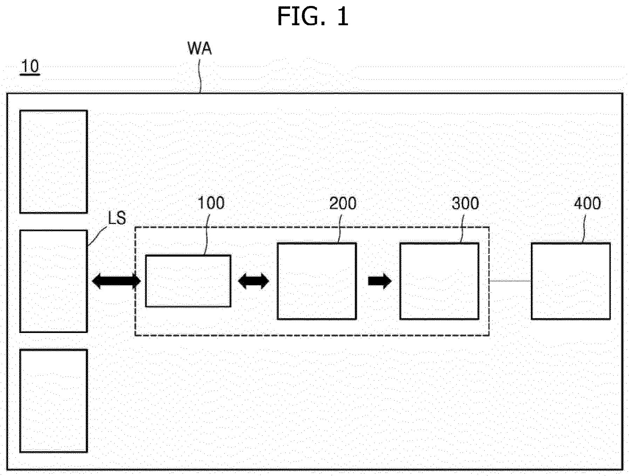

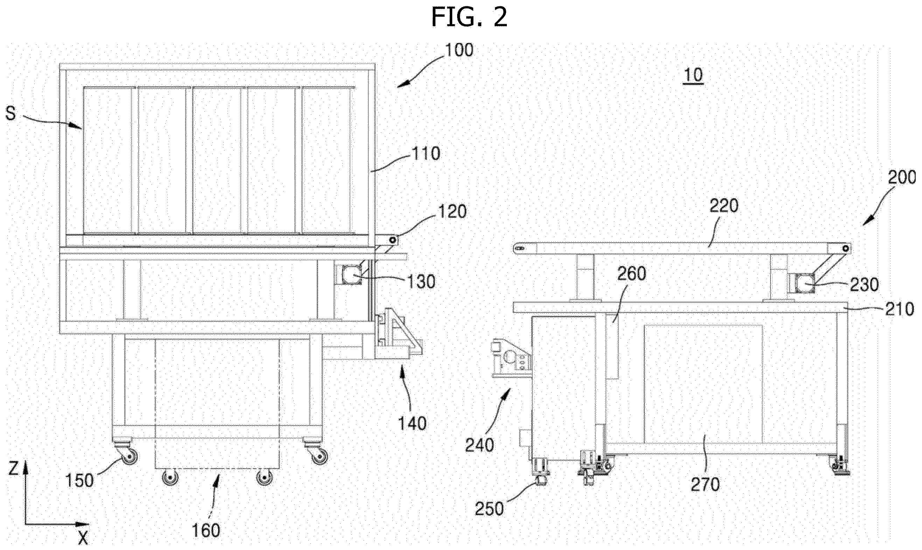

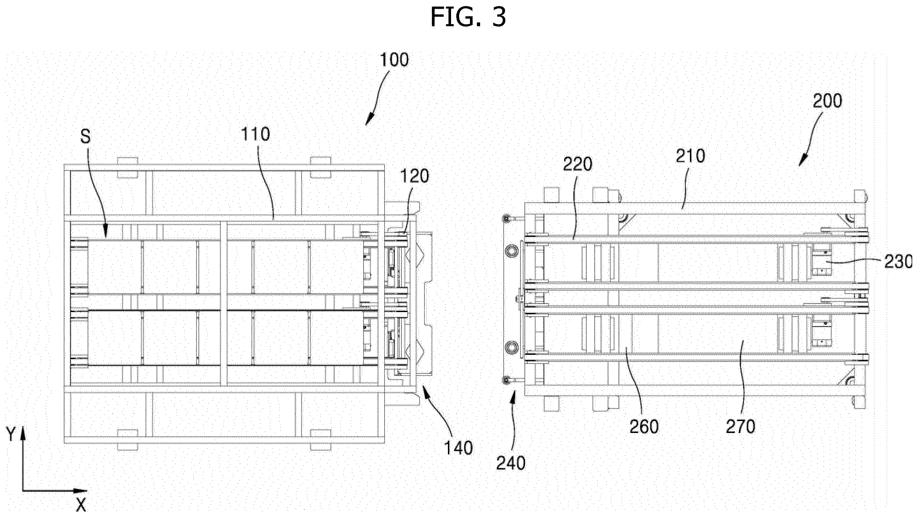

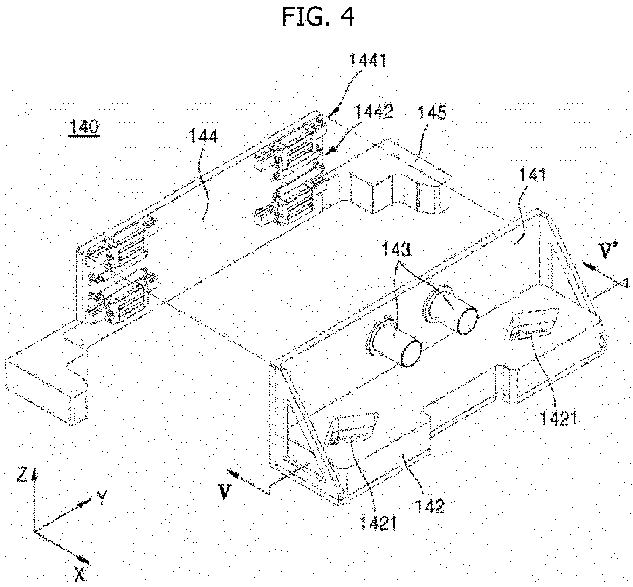

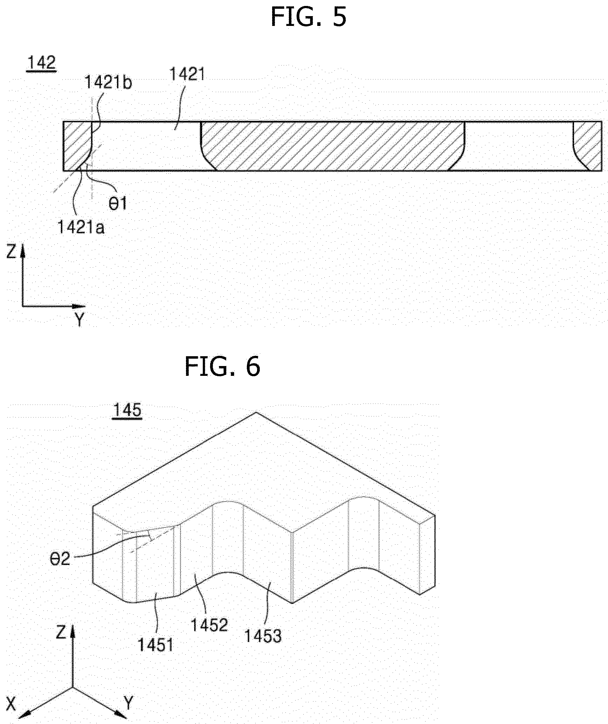

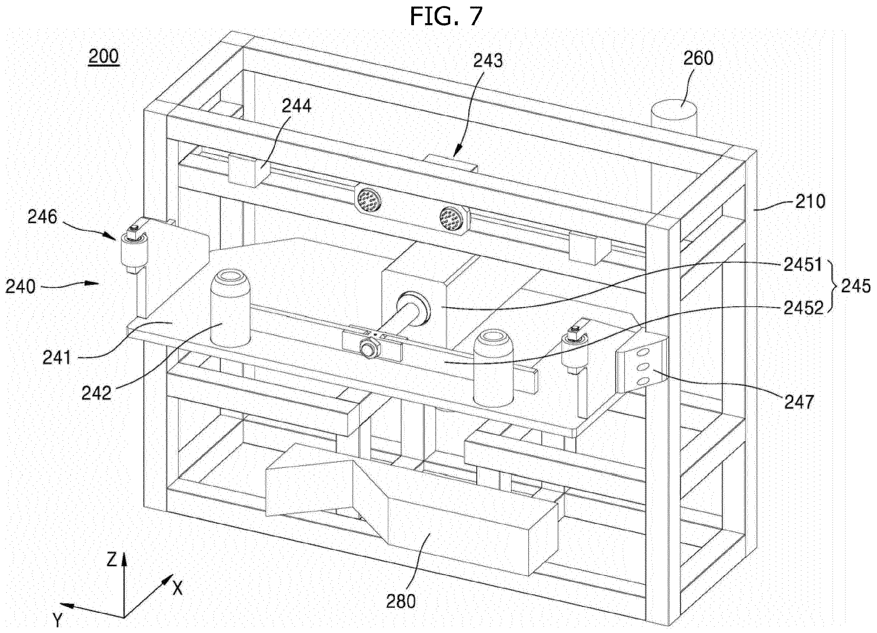

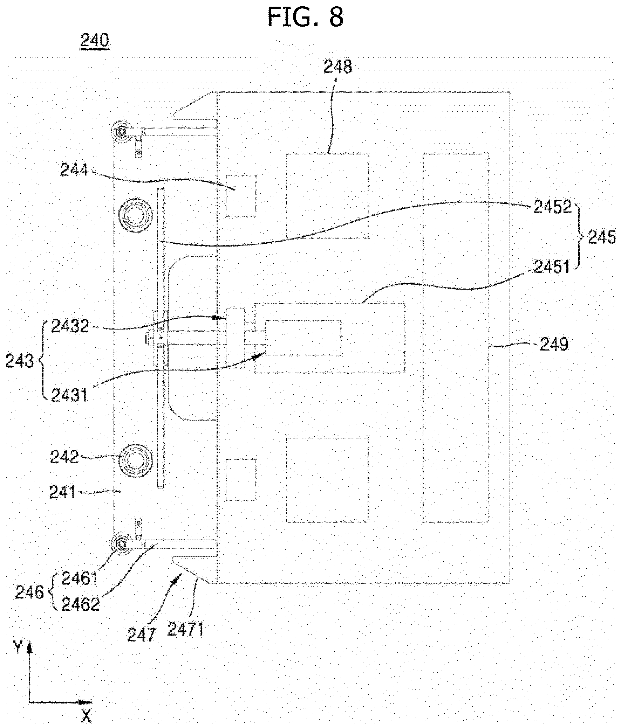

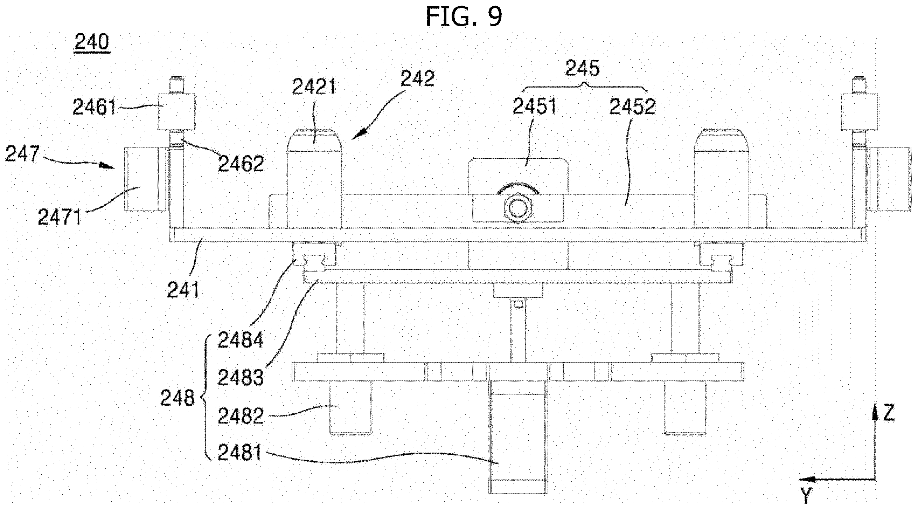

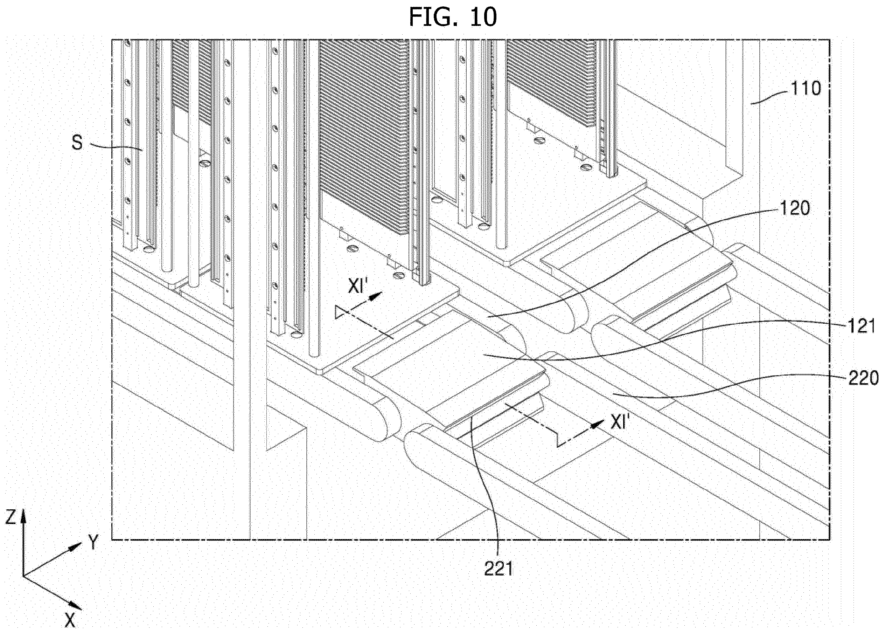

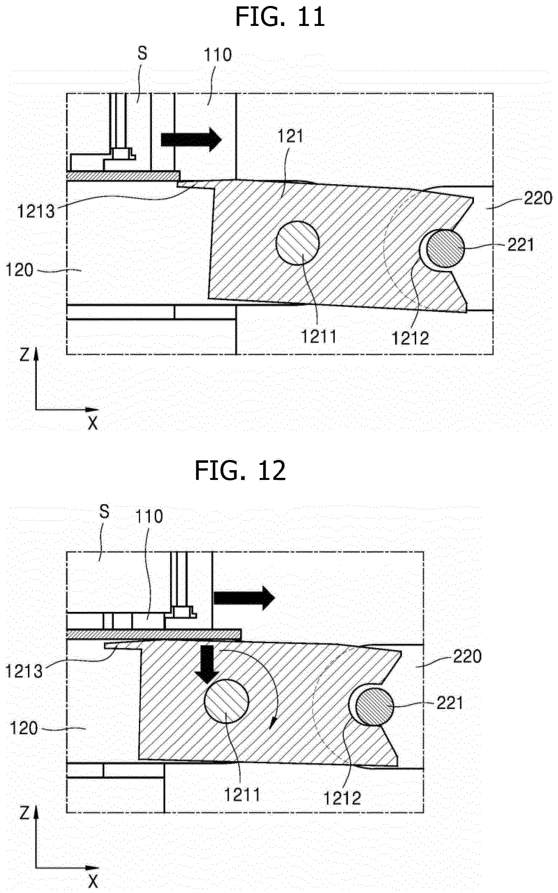

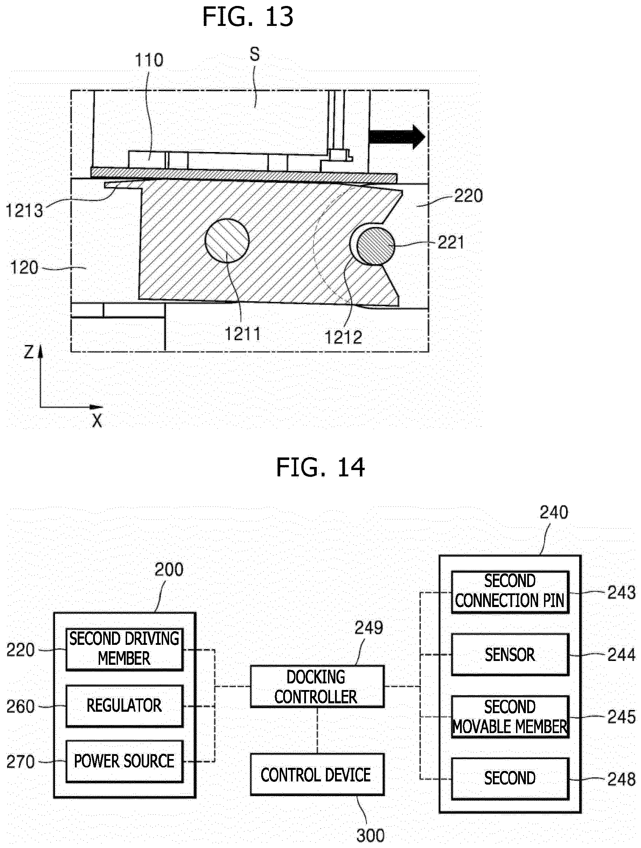

FIG. 1 schematically illustrates a transport system 10. FIG. 2 shows a side view of the transport system 10. FIG. 3 shows a top view of the transport system 10. FIG. 4 illustrates a first docking device 140. FIG. 5 is a cross-sectional view along line V-V' of FIG. 4. FIG. 6 is an enlarged view of a guide block 145. FIG. 7 is an enlarged view of a part of an input device 200. FIG. 8 illustrates a second docking device 240. FIG. 9 illustrates a portion of the second docking device 240. FIG. 10 is an enlarged view of a part of a transport device 100 and the input device 200. FIGS. 11, 12, and 13 illustrate the operation of a coupler 121. FIG. 14 is a control block diagram of a docking controller 249.

Referring to FIGS. 1 to 14, the transport system 10 may include the transport device 100 and the input device 200. The transport system 10 may load various objects S such as wafers from a plurality of loading stations LS on the transport device 100 within a work area WA and then may transport the objects S to the input device 200. In addition to wafers, the object S may include various types of workpieces such as secondary battery electrode plates and solar cells. For example, the object S may be a wafer loaded into a cassette.

The transport system 10 may further include a processing device 300. The processing device 300 may receive the object S from the input device 200 and perform physical and/or chemical processing thereon. For example, the processing device 300 may perform a deposition process on the object S, which is a wafer.

The transport system 10 may further include a control device 400. The control device 400 may be connected to the transport device 100, the input device 200, and the processing device 300 in a wired/wireless manner to transmit or receive signals. The control device 400 may include a processor, a memory, a display, and a communication device. The control device 400 may control the operation of the transport device 100 and the input device 200 by receiving a prestored program or a user's instruction. For example, when the docking controller 249 of the input device 200 is provided outside rather than inside the second docking device 240, the docking controller 249 may be included in the control device 400.

The control device 400 may use a direct circuit structure that executes each control function through one or more microprocessors or other control devices such as a memory, a processor, a logic circuit, and a look-up table. The control device 400 may be implemented with a module, a program, or a part of code that includes one or more executable instructions for executing a particular logic function. The control device 400 may include or may be implemented by a processor such as a central processing unit that executes each function or a microprocessor. The control device 400 may include a communication device capable of transmitting or receiving data with an external device or the like. The communication device may include one or more combinations of a digital modem, a radio frequency (RF) modem, an antenna circuit, a WiFi chip, and associated software, and/or firmware.

The transport device 100 may be a device for transporting the object S to the input device 200 and may move between the loading station LS and the input device 200 within the work area WA. The transport device 100 loads the object S at the loading station LS and then moves to the input device 200 to transport the object S to the input device 200. The transport device 100 may be moved manually by a worker or moved automatically by a transport cart 160.

The transport device 100 may include a transport device body 110, a first transport member 120, a first driving member 130, a first docking device 140, and a driving wheel 150.

The transport device body 110 may support other components of the transport device 100 and may form an exterior of the transport device 100. For example, as shown in FIGS. 2 and 3, the transport device body 110 may include metal frames connected to each other and may have an overall rectangular parallelepiped shape or a shape similar thereto. A space into which the object S may be inserted and supported may be formed inside the transport device body 110. In addition, the first transport member 120 may be connected to the transport device body 110 to support and transport the object S. In addition, the first driving member 130 that drives the first transport member 120 may be connected to the transport device body 110, and the first docking device 140 may be provided on a front surface of the transport device body 110. In addition, the driving wheel 150 may be located below the transport device body 110.

The first transport member 120 is disposed in the transport device body 110 and supports and transports the object S. For example, the first transport member 120 may have a width that is less than or equal to a width of the transport device body 110 and may be located inside the transport device body 110. For example, the first transport member 120 may be a conveyor and driven by the first driving member 130 to transport the object S supported on an upper surface thereof.

The first transport member 120 may include a plurality of first transport members 120 in a width direction of the transport device 100 (for example, a Y-axis direction in FIG. 3). For example, as shown in FIG. 3, the first transport member 120 may include a pair of first transport members 120 for each object S. For example, the first transport member 120 may include four first transport members 120 to correspond to two objects S. Two first transport members 120 may be operated independently by different first driving members 130. The objects S transported by two first transport members 120 may be transported in two rows. The two first transport members 120 are examples, and one or three or more first transport members 120 may be provided.

The first transport member 120 may include the coupler 121. For example, as shown in FIG. 10, the coupler 121 may be rotatably provided at a leading end portion of the first transport member 120, that is, an end portion, facing the input device 200. The coupler 121 may be coupled to a coupling protrusion 221 of the input device 200 to allow the object S to be smoothly transported from the transport device 100 to the input device 200 in a state in which the first docking device 140 is docked to the second docking device 240.

For example, as shown in FIG. 11, the coupler 121 may include a rotation shaft 1211, a coupling groove 1212, and a contact protrusion 1213. The coupler 121 may rotate about the rotation shaft 1211 inserted between a pair of first transport members 120. The rotation shaft 1211 may be provided with an elastic member and thus supported so as to not rotate a certain angle or more even when pressed by the object S. In addition, the rotation shaft 1211 may return to its original position by the elastic member when not pressed by the object S.

The coupling groove 1212 may be disposed at a frontmost portion of the coupler 121 and may be formed to be concave inward. When the first docking device 140 is docked to the second docking device 240, the coupling groove 1212 may be coupled to the coupling protrusion 221 of a second transport member 220 to allow the coupler 121 to be supported on the second transport member 220. For example, the coupling groove 1212 may have a semicircular shape. Alternatively, the coupling groove 1212 may have a shape corresponding to the coupling protrusion 221.

The contact protrusion 1213 may be located at a rear end portion of the coupler 121 and may first come into contact with the object S when the object S is transported from the first transport member 120 to the second transport member 220. For example, as shown in FIG. 11, when the object S is transported and moved toward the second transport member 220, a bottom surface of the object S may come into contact with the contact protrusion 1213, the coupler 121 may rotate counterclockwise around the rotation shaft 1211 due to the weight of the object S, and the coupler 121 may support the bottom surface of the object S.

For example, as shown in FIGS. 12 and 13, as the object S passes the rotation shaft 1211 of the coupler 121, the coupler 121 may rotate clockwise around the rotation shaft 1211. Accordingly, the object S may be smoothly transported to the second transport member 220 along an upper surface of the coupler 121. The coupler 121 may cause the object S to be safely transported without receiving an impact when there is a gap or height difference between the first transport member 120 and the second transport member 220.

The first driving member 130 may be located adjacent to the first transport member 120 and may operate the first transport member 120. For example, as shown in FIGS. 2 and 3, the first driving member 130 may be located below the first transport member 120 to be supported on the transport device body 110. For example, the first driving member 130 may be an electric motor such as a step motor, a linear motor, or a servo motor. The first driving member 130 may be controlled by the docking controller 249 of the second docking device 240 or the control device 400.

The first driving member 130 may receive power from the input device 200. The transport device 100 does not include a separate power source, and the input device 200 may include a power source 270. When the transport device 100 is connected to the input device 200, the power source of the input device 200 may supply power to the first driving member 130 so that the first driving member 130 may operate. Alternatively, the power source 270 may be provided outside the input device 200, for example, provided in the control device 400 or the like.

The first docking device 140 may be located in the transport device 100 and may be connected to the second docking device 240 of the input device 200. For example, as shown in FIGS. 2 and 3, the first docking device 140 may be located on a front surface of the transport device 100 to face the input device 200. The first docking device 140 may be pulled by the second docking device 240 of the input device 200, and the transport device 100 may be aligned with the input device 200. In a state in which the transport device 100 is aligned, the object S may be transported from the first transport member 120 to the second transport member 220. In addition, when the first docking device 140 is connected to the second docking device 240, the power source 270 of the input device 200 may be connected to the first docking device 140 so that the first docking device 140 may receive power from the power source 270.

The first docking device 140 may include a first base 141, a guide plate 142, a first connection pin 143, a first support plate 144, and the guide block 145.

The first base 141 may be located in the first docking device 140 and may support other components of the first docking device 140. For example, the first base 141 may have an L-shape in which two plates are connected to intersect each other in vertical and horizontal directions. The guide plate 142 may be located on an upper surface of the first base 141, and the first connection pin 143 may be located on a front surface of the first base 141. In addition, an opening corresponding to an insertion groove 1421 of the guide plate 142 may be formed in the upper surface of the first base 141.

The guide plate 142 may be located on the first base 141 and may be connected to a docking pin 242 of the second docking device 240. For example, the guide plate 142 may be located on the upper surface of the first base 141, that is, a horizontal surface of the first base 141.

The guide plate 142 may include the insertion groove 1421. For example, as shown in FIGS. 4 and 5, one or more insertion grooves 1421 may be formed to pass through the guide plate 142 in a thickness direction of the first docking device 140 (for example, a Z-axis direction in FIG. 4). When the docking pin 242 is inserted into the insertion groove 1421, and then the second docking device 240 moves rearward, the transport device 100 may be pulled while the first docking device 140 moves together with the second docking device 240. For example, the insertion groove 1421 may include a pair of insertion grooves 1421. The pair of insertion grooves 1421 may be spaced apart from a center of the first docking device 140 in a width direction (for example, the Y-axis direction in FIG. 4). In addition, the first connection pin 143 may be located between the pair of insertion grooves 1421 so that the docking pin 242 may not interfere with the first connection pin 143 when raised or lowered.

The insertion groove 1421 may have a larger dimension in the width direction (for example, the Y-axis direction in FIG. 4) of the first docking device 140 than that in a longitudinal direction (for example, an X-axis direction in FIG. 4). Accordingly, the insertion groove 1421 may have a shape of which a cross-sectional area gradually increases from an end to a center in a width direction. For example, the insertion groove 1421 may have a rhombus shape that is longer in a width direction. Alternatively, the insertion groove 1421 may have an oval shape having a long axis in a width direction. Accordingly, even when the docking pin 242 rises from a position slightly offset from an exact center of the insertion groove 1421, the docking pin 242 may be aligned toward the center by an inner edge of the insertion groove 1421.

The insertion groove 1421 may have a shape in which a cross-sectional area of a partial section gradually decreases in a height direction of the first docking device 140 (for example, the Z-axis direction in FIG. 5). For example, as shown in FIG. 5, the insertion groove 1421 may include an inclined surface 1421a that narrows inward and a vertical surface 1421b that extends upward from the inclined surface 1421a. Accordingly, even when the docking pin 242 is slightly offset from the center of the insertion groove 1421 and comes into contact with the inclined surface 1421a, the docking pin 242 may be aligned toward the inside of the vertical surface 1421b along the inclination of the inclined surface 1421a.

The inclined surface 1421a and the vertical surface 1421b may form an angle θ1. The angle θ1 may range from 30 degrees to 60 degrees. When the angle θ1 is less than 30 degrees, an upper end of the docking pin 242 may not slide along the inclined surface 1421a. In addition, when the angle θ1 exceeds 60 degrees, an area of the inclined surface 1421a may become too narrow, and thus the docking pin 242 may collide with a main body of the guide plate 142 rather than the insertion groove 1421. The angle θ1 may range from 35 degrees to 55 degrees.

The first connection pin 143 may be located on the first base 141 and may be connected to a second connection pin 243 of the second docking device 240. The first connection pin 143 may protrude forward (for example, in the X-axis direction in FIG. 4) from the front surface of the first base 141, that is, a vertical surface of the first base 141. The first connection pin 143 may be connected to the second connection pin 243 to receive power from the input device 200 and transmit the power to the transport device 100. The first connection pin 143 may be connected to the first driving member 130 through internal wiring or the like. Therefore, when the first connection pin 143 is connected to the second connection pin 243, power supplied from the power source 270 of the input device 200 may be transmitted to the first driving member 130, and the first transport member 120 may be operated by the first driving member 130. The first connection pin 143 may include a pair of first connection pins 143. For example, as shown in FIG. 4, the pair of first connection pins 143 may be located between the pair of insertion grooves 1421. The first connection pin 143 may be a female pin of a pogo pin.

The first support plate 144 may be directly connected to the transport device body 110 and connect the first base 141 to the transport device body 110. For example, as shown in FIG. 4, the first support plate 144 may be located behind the first base 141 and may be connected to the first base 141 through a slider 1441 and an elastic member 1442. One or more sliders 1441 and one or more elastic members 1442 may be located on one surface of the first support plate 144. For example, four sliders 1441 may be arranged in two rows in a width direction of the first docking device 140 (for example, the Y- axis direction in FIG. 4), and four elastic members 1442 may be arranged in the height direction (for example, the Z-axis direction in FIG. 4) to each be located between a pair of sliders 1441.

The slider 1441 may allow the first base 141 to move in the width direction of the first docking device 140. For example, the docking pin 242 of the second docking device 240 may be inserted to be biased toward one side of the insertion groove 1421. In this case, the docking pin 242 may be stably inserted into the insertion groove 1421 while the slider 1441 moves in the width direction due to a force by which the docking pin 242 pushes the inclined surface 1421a of the insertion groove 1421. In addition, the elastic member 1442 generates a restoring force as much as the slider 1441 moves so that the insertion groove 1421 is in close contact with the docking pin 242.

The guide block 145 may be located at each side of the first docking device 140 and align a position of the first docking device 140 with respect to the second docking device 240 when the first docking device 140 is docked to the second docking device 240. For example, as shown in FIG. 4, a pair of guide blocks 145 may be located at both sides of the first support plate 144 in the width direction of the first docking device 140 (for example, the Y-axis direction in FIG. 4). The guide block 145 may be connected to the first support plate 144 or the transport device body 110.

The guide block 145 may include an inclined surface 1451, a connection surface 1452, and a seating surface 1453. For example, as shown in FIG. 6, the inclined surface 1451 is located inside a leading end portion of the guide block 145 and is formed to be inclined outward at an angle θ2 with respect to a longitudinal direction (as one embodiment, the X-axis direction in FIG. 6). That is, the inclined surface 1451 may be inclined at the angle θ2 with respect to the connection surface 1452. Accordingly, even when the first docking device 140 and the second docking device 240 are slightly misaligned in a width direction, a guide roller 246 may come into contact with the inclined surface 1451 to be seated on the seating surface 1453 along the connection surface 1452. The connection surface 1452 may extend from an end of the inclined surface 1451 and may intersect vertically with the seating surface 1453.

One or more driving wheels 150 may be located below the transport device body 110 and may be used when a worker manually moves the transport device 100. When a worker uses the driving wheel 150 to push or pull the transport device 100 to position the transport device 100 near the input device 200, a docking operation may be performed by the second docking device 240 of the input device 200.

The transport device 100 may further include the transport cart 160. The transport cart 160 may be used to automatically move the transport device 100 without a worker. The transport cart 160 may be an auto guided vehicle (AGV) capable of moving along a set path or an autonomous mobile robot (AMR) capable of autonomously driving. The transport cart 160 may include a separate power source and a driving device. For example, as shown in FIG. 1, the transport cart 160 may enter a space below the transport device body 110 and may rise to lift the transport device body 110. In this state, the transport cart 160 may be moved to the vicinity of the input device 200 and then detached from the transport device 100, and a docking operation may be performed by the second docking device 240 of the input device 200.

The input device 200 may receive the object S from the transport device 100 to transport the object S to the processing device 300. For example, the input device 200 may be a device provided at a front end portion of the processing device 300 or may be a device independent of the processing device 300. The object S may be transported to the processing device 300 through the transport device 100 and the input device 200 and subjected to certain processing such as heat treatment. The input device 200 may be fixed.

The input device 200 may include an input device body 210, the second transport member 220, a second driving member 230, the second docking device 240, a driving wheel 250, a regulator 260, and the power source 270.

The input device body 210 supports other components of the input device 200 and may form an exterior of the input device 200. For example, as shown in FIGS. 2 and 3, the input device body 210 may include metal frames connected to each other and may have an overall rectangular parallelepiped shape or a shape similar thereto. The second transport member 220 may be located in the input device body 210 and may support and transport the object S. In addition, the second driving member 230 that drives the second transport member 220 may be located in the input device body 210, and the second docking device 240 may be located on a front surface of the input device body 210. In addition, the driving wheel 250 may be located below the input device body 210.

The second transport member 220 may be located in the input device body 210 and may support and transport the object S. For example, the second transport member 220 have a width that is less than or equal to a width of the input device body 210 and may be located inside the input device body 210. For example, the second transport member 220 may be a conveyor and driven by the second driving member 230 to transport the object S supported on an upper surface thereof.

A plurality of second transport members 220 may be arranged in a width direction (Y-axis direction in FIG. 3). For example, as shown in FIG. 3, the second transport member 220 may include a pair of second transport members 220 for each object S. For example, the second transport member 220 may include four second transport members 220 to correspond to two objects S. The pair of second transport members 220 may be operated independently by different second driving members 230. The objects S transported by two first transport members 120 may be transported in two rows. The two second transport members 220 are examples, and one or three or more second transport members 220 may be provided.

The second transport member 220 may include the coupling protrusion 221. For example, as shown in FIGS. 10 to 13, the coupling protrusion 221 may be located between a pair of second transport members 220. The coupling protrusion 221 may be a circular rod and may be located at a leading end portion of the pair of second transport members 220 between which the object S enters. When the first docking device 140 is docked to the second docking device 240, the coupling protrusion 221 may be inserted into the coupling groove 1212 of the coupler 121 to connect the coupler 121 to the second transport member 220.

The second driving member 230 may be located adjacent to the second transport member 220 and operate the second transport member 220. For example, as shown in FIGS. 2 and 3, the second driving member 230 may be located below the second transport member 220 to be supported on the input device body 210. The second driving member 230 may be an electric motor such as a step motor, a linear motor, or a servo motor. The second driving member 230 may be controlled by the docking controller 249 of the second docking device 240 or the control device 400.

The second docking device 240 may be located on the front surface of the input device body 210 and may be docked to the first docking device 140. For example, as shown in FIGS. 2 and 3, the second docking device 240 may be at a side receiving the object S from the transport device 100. In a state in which the transport device 100 is located at the input device 200, the second docking device 240 may face the first docking device 140.

The second docking device 240 may include a second base 241, a docking pin 242, the second connection pin 243, a sensor 244, a first movable member 245, a guide roller 246, an alignment protrusion 247, a second movable member 248, and a docking controller 249.

The second base 241 may support some components of the second docking device 240 and may be located in the input device body 210. For example, as shown in FIG. 7, the second base 241 may have a wide flat shape, and the docking pin 242 and the guide roller 246 may be located thereon. The second base 241 may be moved forward or rearward and raised or lowered by the first movable member 245 and the second movable member 248 to insert the docking pin 242 into the insertion groove 1421 and align and pull the first docking device 140.

One or more docking pins 242 may be disposed on an upper surface of the second base 241. For example, as shown in FIGS. 7 to 9, the docking pin 242 may include a pair of docking pins 242 spaced apart from each other in a width direction (Y-axis direction in FIG. 7) on the upper surface of the second base 241. The number of docking pins 242 may be the same as the number of insertion grooves 1421. The docking pin 242 may move integrally with the second base 241 and inserted into or detached from the insertion groove 1421. When the docking pin 242 rises from the bottom of the insertion groove 1421 and inserted into the insertion groove 1421, and then the second base 241 moves rearward, the first docking device 140 may move toward the second docking device 240 by the docking pin 242.

For example, as shown in FIG. 9, an upper portion 2421 of the docking pin 242 may have a shape that narrows upward. Accordingly, even when the docking pin 242 is inserted to be slightly misaligned with the insertion groove 1421, the docking pin 242 may slidably enter the insertion groove 1421while the inclined upper portion 2421 comes into contact with the insertion groove 1421.

The second connection pin 243 may be located in the input device body 210 and may be connected to the first connection pin 143 when the first docking device 140 is docked to the second docking device 240. For example, as shown in FIG. 7, the second connection pin 243 may be inserted into the front surface of the input device body 210 and may be located above the second base 241. When the second connection pin 243 is connected to the first connection pin 143, the power source 270 may be connected to the transport device 100. The second connection pin 243 may include a pair of second connection pins 243 similar to the first connection pin 143. For example, as shown in FIG. 7, the pair of second connection pins 243 may be located between a pair of sensors 244. For example, the second connection pin 243 may be a male pin of a pogo pin.

The second connection pin 243 may include a pin body 2431 and a pin cylinder 2432. The pin body 2431 may be connected to the pin cylinder 2432 and may move forward or rearward according to the forward or rearward movement of the pin cylinder 2432. When the sensor 244 detects the transport device 100 and the alignment of the first docking device 140 is completed, as the pin cylinder 2432 moves forward, the pin body 2431 may be connected to the first connection pin 143. After the transport operation is completed, as the pin cylinder 2432 moves rearward again, the pin body 2431 may be detached from the first connection pin 143. In one embodiment, the pin cylinder 2432 may be a pneumatic cylinder.

For example, as shown in FIGS. 7 and 8, the sensor 244 may be located on the front surface of the input device body 210 and may be located above the second base 241. For example, two sensors 244 may be disposed with the second connection pin 243 interposed therebetween. The sensor 244 may include one or more of various types of sensors such as a laser, an optical sensor, and an ultrasonic sensor. The sensor 244 may detect the transport device 100 and may measure a distance to the transport device 100, and transmit information on the measured distance to the docking controller 249. The docking controller 249 may control the second docking device 240 based on the information received from the sensor 244.

The first movable member 245 may be located in the input device body 210 and may move the second base 241 in a longitudinal direction (for example, the X-axis direction in FIG. 7). As the second base 241 moves forward or rearward by the operation of the first movable member 245, the docking pin 242 and the guide roller 246 may also move forward or rearward together.

The first movable member 245 may include a first cylinder 2451 and a connection member 2452. For example, as shown in FIG. 7, the first cylinder 2451 may be connected to the second base 241 through the connection member 2452. The first cylinder 2451 operates to move the connection member 2452 forward or rearward, thereby allowing the second base 241 to move forward or rearward. The connection member 2452 may have a plate or rod shape protruding from the upper surface of the second base 241. In addition, the first cylinder 2451 may be a pneumatic cylinder. For example, the first movable member 245 may be located between the pair of docking pins 242.

The guide roller 246 may be located on the second base 241, may assist in aligning the first docking device 140 and the second docking device 240, and may limit the insertion position of the first docking device 140. For example, the guide rollers 246 may be located on the upper surface of the second base 241 and spaced apart from each other in the width direction (for example, the Y-axis direction in FIG. 7) such that the docking pin 242 is disposed therebetween.

The guide roller 246 may include a roller 2461 and a support 2462. A pair of supports 2462 may be provided at both sides of the second base 241, and the roller 2461 may be provided at a leading end portion thereof. The roller 2461 may be located above the docking pin 242 due to the support 2462. For example, an interval between a pair of rollers 2461 may be less than an interval between the inclined surfaces 1451 of the pair of guide blocks 145. Accordingly, even when the transport device 100 is slightly offset with respect to the input device 200, the pair of rollers 2461 may be stably positioned between the pair of guide blocks 145.

The alignment protrusions 247 are spaced apart from each other on the input device body 210 and align the first docking device 140 and the second docking device 240 together with the guide roller 246. In one embodiment, a pair of alignment protrusions 247 may be provided at both sides of the second base 241 in the width direction (for example, the Y-axis direction in FIG. 7). The alignment protrusion 247 may be located at a side of the input device body 210 adjacent to the second base 241 and may be spaced a certain interval apart from the second base 241. Accordingly, even when the first movable member 245 moves forward or rearward, the alignment protrusion 247 may be fixed.

The alignment protrusion 247 may include an inclined surface 2471 at an outer side thereof in a width direction. The inclined surface 2471 obliquely extends inward at a certain angle toward a leading end portion of the alignment protrusion 247. The inclined surface 2471 comes into contact with the inclined surface 1451 of the guide block 145 to guide the first docking device 140 inward in a width direction.

A distance between the pair of alignment protrusions 247 may be smaller than a distance between the pair of guide blocks 145. In addition, the pair of alignment protrusions 247 may be located outside the guide roller 246 in a width direction. Accordingly, the alignment protrusions 247 may define the maximum width by which the first docking device 140 and the second docking device 240 may be docked in the width direction. A user or the transport cart 160 may position the transport device 100 adjacent to the input device 200 based on a position of the alignment protrusion 247.

The second movable member 248 may be located in the input device body 210 and may move the second base 241 in a height direction (for example, the Z-axis direction in FIG. 9). As the second base 241 is raised or lowered by the operation of the second movable member 248, the docking pin 242 and the guide roller 246 may also be raised or lowered together. In one embodiment, the second movable member 248 may be located below the second base 241.

The second movable member 248 may include a second cylinder 2481, a guide bar 2482, a second support plate 2483, and a slider 2484.

The second cylinder 2481 may be located in the second movable member 248, and an end portion thereof may be connected to the second support plate 2483. The second cylinder 2481 may be located at a central portion of the second support plate 2483 and may raise or lower the second support plate 2483 in a height direction. The second cylinder 2481 may be a pneumatic cylinder and may be controlled by the pneumatic regulator 260. A plurality of guide bars 2482 are provided below the second support plate 2483 and support the second support plate 2483 so as to not tilt or shake during a raising/lowering process. For example, the plurality of guide bars 2482 may be spaced apart from each other in width and longitudinal directions with the second cylinder 2481 as a center. A plurality of sliders 2484 are provided on an upper surface of the second support plate 2483 and are connected to a lower surface of the second base 241. When the first movable member 245 operates, the slider 2484 allows the second base 241 to move on the second support plate 2483. A pair of sliders 2484 may be provided on the upper surface of the second support plate 2483 in a width direction.

The docking controller 249 may control the docking operation of the second docking device 240. For example, the docking controller 249 may be located inside or outside the second docking device 240 and may be connected to other components of the second docking device 240 in a wired and/or wireless manner. The docking controller 249 may receive a detection signal of the transport device 100 from the sensor 244 and may control the first movable member 245 and the second movable member 248 to control the docking pin 242 to be inserted into the insertion groove 1421. In addition, the docking controller 249 may move the second connection pin 243 forward to be connected to the first connection pin 143 and may supply power of the power source 270 to the first driving member 130. In addition, when the first driving member 130 operates and an operation of transporting the object S is performed by the first transport member 120, the docking controller 249 may control the second driving member 230 to operate to transport the object S using the second transport member 220. The docking controller 249 may include a processor, a memory, a display, and a communication device. For example, the docking controller 249 may be connected to the control device 400 in a wire and/or wireless manner and may operate under the instruction of the control device 400.

A plurality of driving wheels 250 may be located on a lower surface of the input device body 210. Basically, the input device 200 is fixed, but when the input device 200 needs to move, the input device 200 may be unfixed and moved using the driving wheels 250.

The regulator 260 may be located in the input device body 210 and may supply air to the second connection pin 243, the first movable member 245, and the second movable member 248. For example, the regulator 260 may be a pneumatic regulator that includes a valve and may receive a control signal from the docking controller 249 to supply air to the pin cylinder 2432 of the second connection pin 243. The pin cylinder 2432 may receive air to move forward or rearward to connect the pin body 2431 to the first connection pin 143 or detach the pin body 2431 from the first connection pin 143. In addition, by supplying air to the first cylinder 2451 of the first movable member 245 and the second cylinder 2481 of the second movable member 248, the first movable member 245 and the second movable member 248 may move forward or rearward or upward or downward. In one embodiment, the regulator 260 may be connected to an air supply source that is not shown.

The power source 270 may be located inside the input device body 210 and may supply power to the transport device 100 and the input device 200. For example, the power source 270 may receive a control signal from the docking controller 249 or the control device 400 to supply power to the second driving member 230, the sensor 244, the regulator 260, and the like of the input device 200. In addition, in a state in which the first connection pin 143 is connected to the second connection pin 243, the power source 270 may supply power to the transport device 100 through the first connection pin 143. Accordingly, the first driving member 130 of the transport device 100 that does not include a separate power source may receive power from the power source 270 to operate the first transport member 120. In another embodiment, the power source 270 may be included in the processing device 300 rather than the input device 200. Alternatively, the power source 270 may be provided separately and not included in the input device 200 or the processing device 300.

A marker 280 may be located in the input device 200 and may be used for the transport cart 160 to recognize the input device 200. For example, as shown in FIG. 7, the marker 280 may be located on a front surface of the input device 200, that is, at a side through which the object S enters from the transport device 100. The marker 280 may be located at a lower portion of the input device body 210, and the transport cart 160 may transport the transport device 100 by detecting a position and distance of the marker 280 using a vision camera or an optical or ultrasonic sensor.

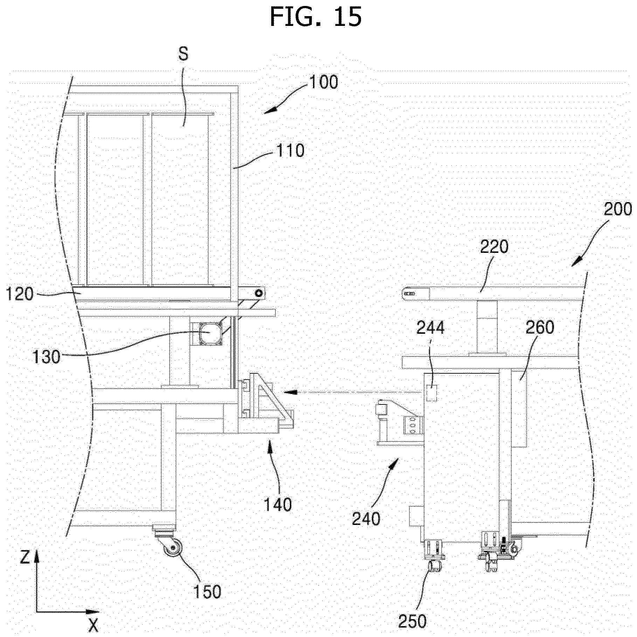

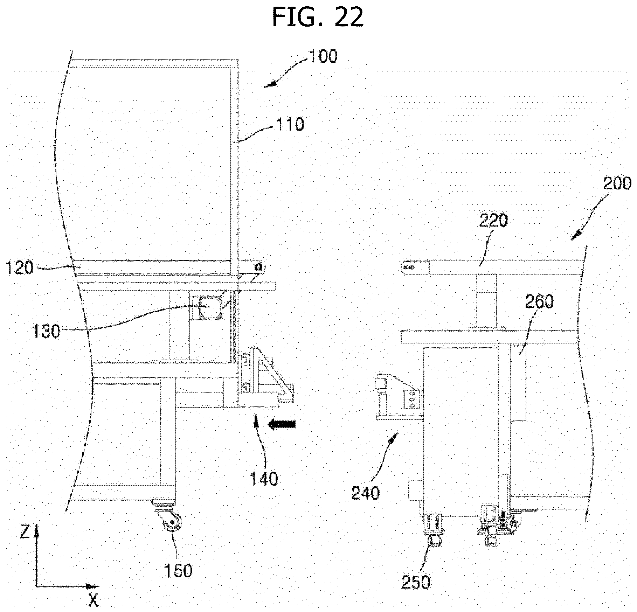

FIGS. 15 to 22 illustrate docking and undocking operations of the transport device 100 and the input device 200.

The docking and undocking operations of the transport device 100 and the input device 200 will be described with reference to FIGS. 1 to 22.

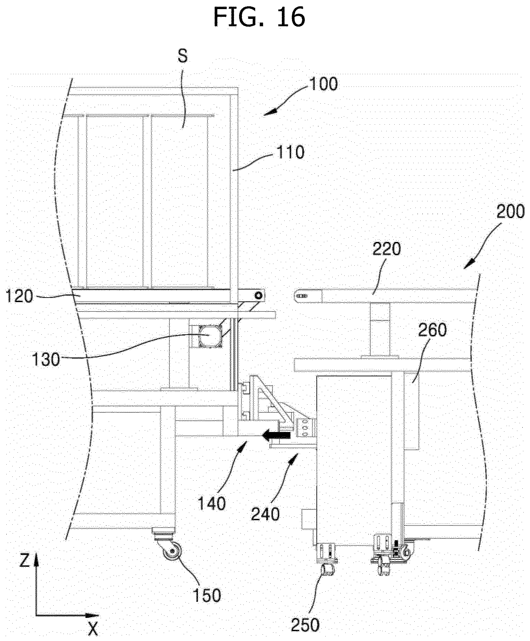

First, the transport device 100 loads the object S at the loading station LS and then moves to the input device 200. A worker may directly transport the transport device 100 using the driving wheel 150, or the transport cart 160 may automatically transport the transport device 100. When the transport device 100 approaches the input device 200, for example, the sensor 244 of the second docking device 240 detects the transport device 100 as shown in FIG. 15. The sensor 244 may continuously measure a distance to the transport device 100 and may notify the docking controller 290 of the measured distance. When a distance detected by the sensor 244 is a preset distance or less, the docking controller 290 supplies air to the second movable member 248 using the regulator 260, and the second movable member 248 moves forward toward the first docking device 140 (see FIG. 16).

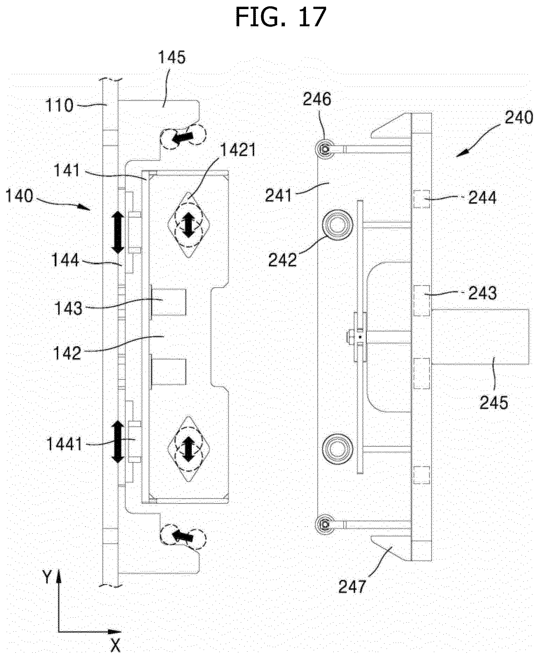

Even when the first docking device 140 and the second docking device 240 are not aligned with each other in an initial state in which the transport device 100 reaches and stops near the input device 200, the first docking device 140 and the second docking device 240 may be aligned during a docking process. When the second docking device 240 approaches the first docking device 140, the guide roller 246 may first come into contact with the guide block 145 and then may move inward along the inclined surface 1451. Accordingly, positions of the first docking device 140 and the second docking device 240 may be primarily aligned in the width direction (for example, the Y-axis direction in FIG. 17). In addition, the alignment protrusions 247 located at both sides of the guide roller 246 may also limit the positions of the first docking device 140 and the second docking device 240 in the width direction. In addition, when the docking pin 242 is inserted into the insertion groove 1421, the upper portion 2421 of the docking pin 242 has a shape that narrows upward, and the inclined surface of the insertion groove 1421 also has a shape that narrows upward. Accordingly, even when the docking pin 242 rises in a state of being slightly misaligned from the center of the insertion groove 1421, the docking pin 242 may naturally enter the insertion groove 1421. In addition, since the insertion groove 1421 has a shape of which a dimension in a width direction is greater than that in a longitudinal direction, the docking pin 242 may more easily enter the insertion groove 1421. In addition, the slider 1441 and the elastic member 1442 provided in the first docking device 140 allow the first base 141 to move a certain distance in the width direction. Accordingly, even when the docking pin 242 is inserted into the insertion groove 1421 slightly misaligned, the position of the first docking device 140 may be corrected while the slider 1441 moves. In addition, while the elastic member 1442 presses the first base 141 in an opposite direction, the first docking device 140 and the second docking device 240 may be firmly connected.

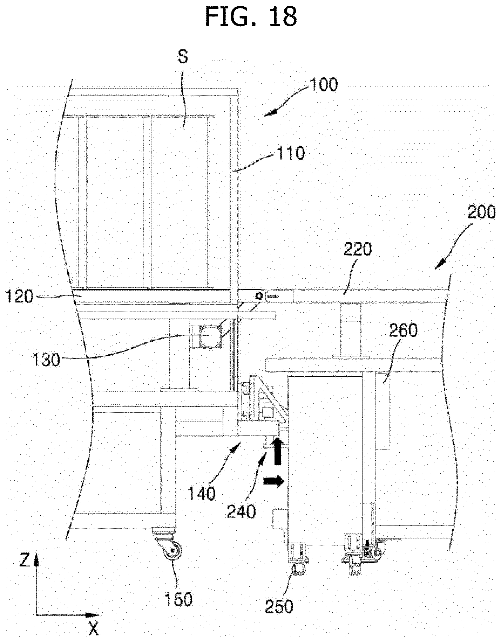

Next, the docking controller 249 supplies air to the first movable member 245 using the regulator 260, and the first movable member 245 is raised so that the docking pin 242 is completely inserted into the insertion groove 1421. When the docking controller 249 supplies air to the second movable member 248 again using the regulator 260, the second movable member 248 moves rearward to pull the first docking device 140 to the second docking device 240 (see FIG. 18).

In a state in which the first docking device 140 is pulled to the second docking device 240, the coupler 121 of the first transport member 120 may be coupled to the coupling protrusion 221 of the second transport member 220. As the second docking device 240 pulls the first docking device 140, the coupler 121 may approach the coupling protrusion 221, and the coupling protrusion 221 may be inserted into the coupling groove 1212 of the coupler 121. Accordingly, the coupler 121 may be supported on the second transport member 220.

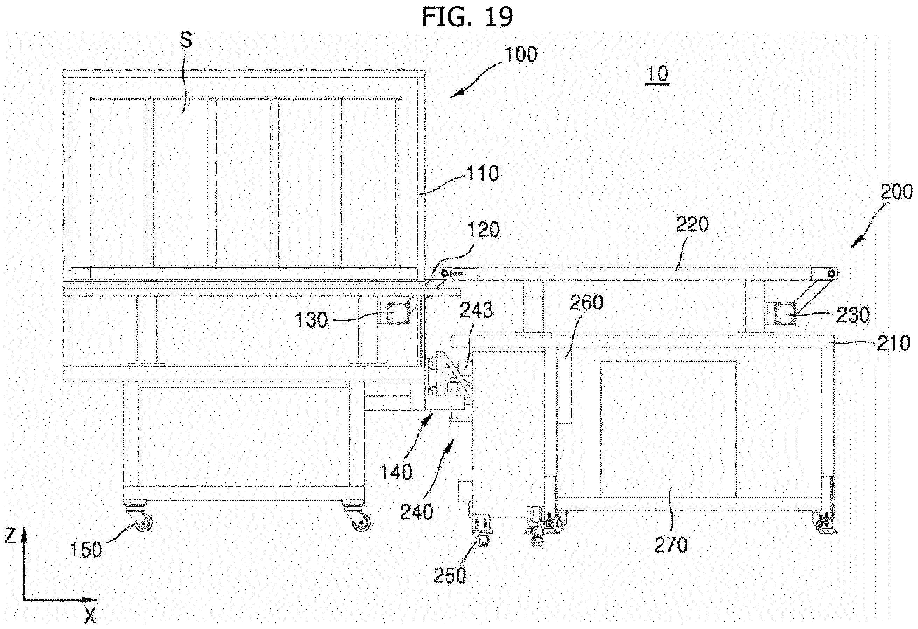

Next, the docking controller 249 supplies air to the second connection pin 243 using the regulator 260, and the second connection pin 243 moves forward toward the first connection pin 143 (see FIG. 19). When the second connection pin 243 is connected to the first connection pin 143, the transport device 100 may be connected to the power source 270. The docking controller 249 causes the power source 270 to supply power to the first driving member 130 of the transport device 100. In one embodiment, in a state in which the first connection pin 143 is connected to the second connection pin 243, the docking pin 242 may maintain a state of being inserted into the insertion groove 1421. In another embodiment, in a state in which the first connection pin 143 is connected to the second connection pin 243, the docking controller 249 may control the first movable member 245 and the second movable member 248 to detach the docking pin 242 from the insertion groove 1421.

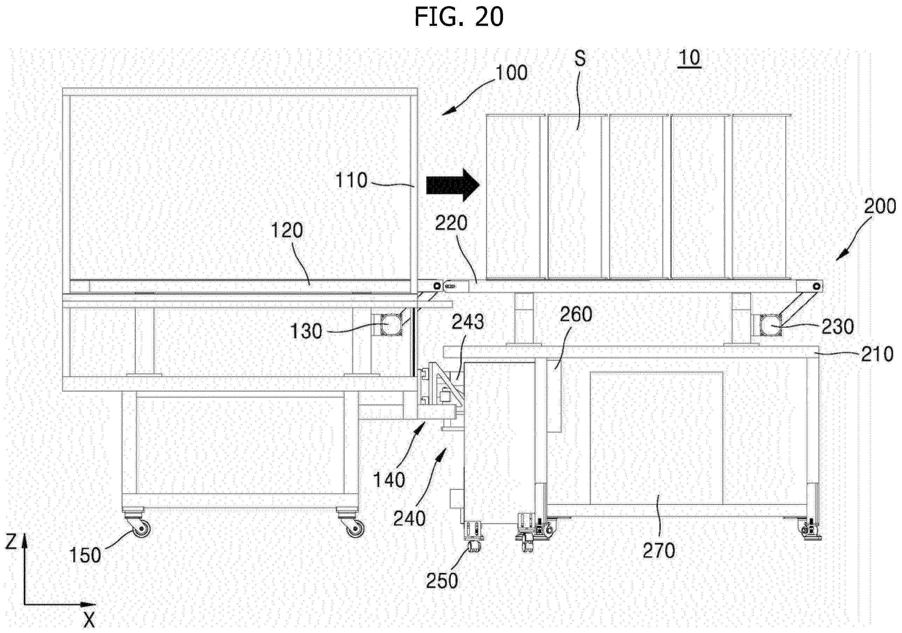

When the first driving member 130 receives power and operates, the first transport member 120 operates, and thus the object S moves on the transport device 100. In addition, the docking controller 249 also operates the second driving member 230 to allow the second transport member 220 to receive the object S from the first transport member 120 and transport the object S (see FIG. 20).

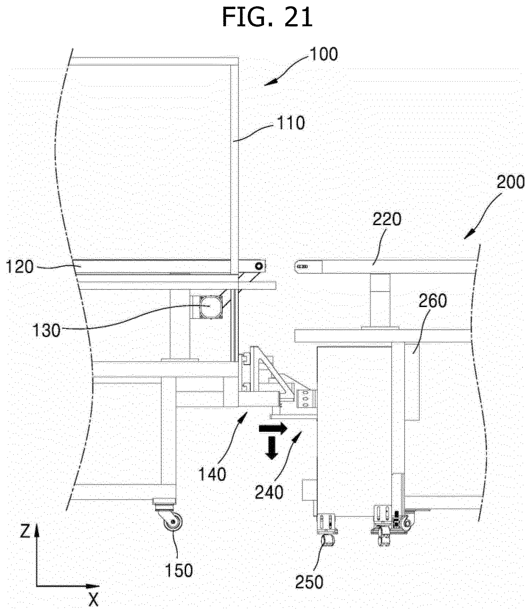

When the object S is completely transported to the input device 200, the docking controller 249 undocks the first docking device 140 from the second docking device 240. In an operation opposite to the docking operation, the second connection pin 243 moves rearward to be disconnected from the first connection pin 143. When the docking pin 242 is in a state of being inserted into the insertion groove 1421, the second movable member 248 is lowered to detach the docking pin 242 from the insertion groove 1421, and the first movable member 245 moves rearward to separate the second docking device 240 from the first docking device 140 (see FIG. 21). Alternatively, when the docking pin 242 has already been detached from the insertion groove 1421, only the first movable member 245 moves rearward so that the second docking device 240 is separated from the first docking device 140. A worker may directly transport the transport device 100, or a transport cart 160 may transport the transport device 100.

### [Industrial Applicability]

Several embodiments of the present disclosure can be used in industries relating to transport systems and transport methods.

## Claims

1. A transport system comprising:
a transport device including a first transport member configured to transport an object, a first driving member configured to drive the first transport member, and a first docking device; and
an input device including a second transport member configured to transport the object, a second driving member configured to drive the second transport member, and a second docking device,
wherein the first docking device includes a first connection pin, and
the second docking device includes a second connection pin,
wherein the second docking device pulls the first docking device to the input device and connects the second connection pin to the first connection pin to connect a power source to the transport device.

2. The transport system of claim 1, wherein the first docking device includes a first base configured to support the first connection pin and a guide plate connected to the first base and including an insertion groove, and
the second docking device includes a second base configured to support the second connection pin, a first movable member configured to move the second base forward or rearward, a second movable member configured to raise or lower the second base, a docking pin which is connected to the second base and has an upper portion having a shape of which a cross-sectional decreases in an upward direction, and a sensor,
wherein, when the sensor detects the transport device, the first movable member and the second movable member operate to insert the docking pin into the insertion groove and then pull the first docking device to the first docking device.

3. The transport system of claim 2, wherein the first docking device further includes a pair of guide blocks located at both sides of the first base and each including an inclined surface on an inner surface facing the first base, and
the second docking device further includes a pair of rollers located at both sides of the second base and having an interval that is less than an interval between the pair of guide blocks, and a pair of alignment protrusions located outside the pair of rollers and each having an inclined surface at an outer side thereof.

4. The transport system of claim 2, wherein the first docking device further includes a support plate located on the first base, a slider located on the support plate and movable in a width direction, and an elastic member located on the support plate, and
the insertion groove has a shape of which a dimension in a longitudinal direction is greater than a dimension in a width direction and includes an inclined surface having a shape of which a cross-sectional area decreases in an upward direction, and a vertical surface extending from the inclined surface.

5. The transport system of claim 1, wherein the transport device does not include a power source, and
when the second connection pin is connected to the first connection pin, the second docking device supplies power from the power source to the transport device to operate the first driving member.

6. The transport system of claim 1, wherein the first transport member further includes a coupler which is rotatable and includes a coupling groove formed in a leading end portion, and
the second transport member further includes a coupling protrusion coupled to the coupling groove of the coupler.

7. A transport method comprising:
moving a transport device to an input device;
detecting, by a second docking device of the input device, the transport device;
inserting, by a first movable member and a second movable member, a docking pin of the second docking device into an insertion groove of a first docking device of the transport device;
pulling, by the first movable member, the first docking device to the second docking device; and
connecting a first connection pin of the first docking device to one or more second connection pins of the second docking device to connect a power source to the transport device.

8. The transport method of claim 7, wherein, after the docking pin is inserted into the insertion groove, the first movable member operates to move the docking pin forward, and then the second movable member operates to raise and insert the docking pin into the insertion groove, and
the pulling of the first docking device to the second docking device includes operating the first movable member to move the docking pin inserted into the insertion groove rearward.

9. The transport method of claim 7, wherein, after the power source is connected to the transport device, the first transport member of the transport device receives power from the power source to transport an object to the second transport member of the input device.

10. The transport method of claim 7, wherein, after the first transport member pulls the first docking device to the second docking device, the first transport member of the transport device is connected to the second transport member of the input device through a coupler.
